# EUROPÄISCHE PATENTANMELDUNG

(11) **EP 4 842 152 A1**
(43) Veröffentlichungstag der Anmeldung: **18.11.2026**
(21) Anmeldenummer: 25176151.6
(22) Anmeldetag: 13.05.2025
(51) Int. Cl.: H05K 7/20, F28F 13/16

(54) **VORRICHTUNG ZUR ENTWÄRMUNG EINES SYSTEMS, VERFAHREN FÜR EINE AUSLEGUNG DER VORRICHTUNG ZUR ENTWÄRMUNG DES SYSTEMS UND COMPUTERPROGRAMMPRODUKT**

(71) Anmelder: Siemens Aktiengesellschaft, 80333 München (DE)
(72) Erfinder: Karmazin, Roman, 81829 München (DE); Wolff, Andreas, 81825 München (DE)
(74) Vertreter: Siemens Patent Attorneys

(57) **Zusammenfassung**

Vorrichtung zur Entwärmung eines Systems, Verfahren für eine Auslegung der Vorrichtung zur Entwärmung des Systems und Computerprogrammprodukt

Es wird eine Vorrichtung zur Entwärmung eines Systems umfassend eine elektrisch leitfähige Bahnstruktur und eine zu entwärmende Fläche des Systems vorgeschlagen, wobei die elektrisch leitfähige Bahnstruktur, für eine Entwärmung der zu entwärmenden Fläche, auf die zu entwärmende Fläche aufgebracht ist, wobei die Bahnstruktur wenigstens zwei Elektroden umfasst, wobei eine erste Elektrode elektrisch geerdet ausgebildet ist, eine zweite Elektrode als eine Anode gegenüber der ersten Elektrode ausgebildet ist und die erste und zweite Elektrode jeweils benachbart und/oder parallel zueinander in einer gemeinsamen räumlichen Ebene angeordnet sind und die zweite Elektrode mit in der selben räumlichen Ebene angeordneten pfeilartigen und/oder streifenartigen Flächen als Ausläufer besetzt ist, welche parallel zueinander angeordnet sind, wobei die Ausläufer mit einem jeweiligen Ende auf die jeweils benachbarte parallel angeordnete erste Elektrode zeigen und bei einer anliegenden Hochspannung dazu ausgebildet sind, ein die Ausläufer umgebendes Fluid zu ionisieren.

Weiterhin betrifft die Erfindung ein Verfahren und ein Computerprogrammprodukt.

## Beschreibung

Die Erfindung betrifft eine Vorrichtung gemäß dem Oberbegriff des Patentanspruches 1 sowie ein Verfahren gemäß dem Oberbegriff des Patentanspruches 9 und ein Computerprogrammprodukt gemäß dem Oberbegriff des Patentanspruches 10.

Zur Entwärmung von elektrischen Maschinen oder Recheneinheiten werden insbesondere Kühlkörper aus Materialien mit einer guten Wärmeleitfähigkeit verwendet. Dieser passive Ansatz zeigt Limitationen, sobald höhere Entwärmungsleistungen bei kleiner Bauform gefordert sind, da sich die Oberfläche der Kühlkörper für eine erhöhte Entwärmungsleistung stark vergrößern muss.

Als Alternative können bei elektrischen Maschinen wie Motoren und Generatoren Lüfterräder auf einer Motorwelle angeordnet oder bei Recheneinheiten Lüfterräder mit eigenem Antrieb montiert werden. Beide Varianten führen weiterhin zu einer Volumenvergrößerung des Motors oder der Recheneinheit und die Lüfterräder erzeugen erhebliche Geräusche. Im Fall des Lüfterrades mit eigenem Antrieb wird noch eine separate elektrische Kontaktierung für eine Energiezuführung benötigt.

Eine weitere Alternative können elektrohydrodynamische Pumpen sein, sie müssen jedoch neben der elektrischen Feldstärke, zur Ionisierung eines für eine Entwärmung genutzten Fluids, auch genügend große Elektrodenflächen zur Verfügung stellen, um eine gewünschte Entwärmungsleistung bereitzustellen. Herkömmliche elektrohydrodynamische Pumpen nutzen eine ringförmige Elektrodenform, welche nur den Rand des Rings zur Ionisierung nutzt. Eine Steigerung der Entwärmungsleistung und eine Minimierung der Einbaugröße stehen hierbei in Konflikt, was sich in einem relativ geringen Wirkungsgrad bzw. einer geringeren Effizienz herkömmlicher elektrohydrodynamische Pumpen äußert.

Der vorliegenden Erfindung liegt die Aufgabe zugrunde, ein System effizienter zu entwärmen.

Die Aufgabe wird durch eine Vorrichtung mit den Merkmalen des unabhängigen Patentanspruches 1 sowie durch ein Verfahren mit den Merkmalen des unabhängigen Patentanspruches 9 und ein Computerprogrammprodukt gemäß dem unabhängigen Patentanspruch 10 gelöst. In den abhängigen Patentansprüchen sind vorteilhafte Ausgestaltungen und Weiterbildungen der Erfindung angegeben.

Die erfindungsgemäße Vorrichtung zur Entwärmung eines Systems umfasst eine elektrisch leitfähige Bahnstruktur und eine zu entwärmende Fläche des Systems.

Die elektrisch leitfähige Bahnstruktur ist für eine Entwärmung der zu entwärmenden Fläche auf die zu entwärmende Fläche aufgebracht, wobei die Bahnstruktur wenigstens zwei Elektroden umfasst, wobei eine erste Elektrode elektrisch geerdet ausgebildet ist, eine zweite Elektrode als eine Anode gegenüber der ersten Elektrode ausgebildet ist und die erste und zweite Elektrode jeweils benachbart und/oder parallel zueinander in einer gemeinsamen räumlichen Ebene angeordnet sind und die zweite Elektrode mit in der selben räumlichen Ebene angeordneten pfeilartigen und/oder streifenartigen Flächen als Ausläufer besetzt ist, welche parallel zueinander angeordnet sind, wobei die Ausläufer mit einem jeweiligen Ende auf die jeweils benachbarte parallel angeordnete erste Elektrode zeigen und bei einer anliegenden Hochspannung dazu ausgebildet sind, ein die Ausläufer umgebendes Fluid zu ionisieren.

Die leitfähige Bahnstruktur kann eine Anordnung von elektrisch leitfähigen Elementen sein, die dazu dient, elektrischen Strom zu leiten. Typischerweise besteht sie aus einem oder mehreren Leiterbahnen, die auf einem isolierenden Substrat oder in einer Leiterplatte verlaufen können.

Entwärmung kann den Prozess, bei dem Wärme aus einem System oder Bauteil abgeführt wird, um eine Überhitzung zu verhindern, bezeichnen. Dabei kann die Wärme durch verschiedene Methoden wie Konvektion, Strahlung oder Leitung an die Umgebung abgegeben werden. Ziel ist es, die Temperatur des Systems oder Bauteils auf einem Niveau zu halten, bei dem es effizient und sicher betrieben werden kann. Entwärmung spielt eine wichtige Rolle in vielen technischen Anwendungen, wie zum Beispiel in der Elektronik, Maschinenbau oder Energietechnik, um eine Überhitzung und daraus resultierende Schäden zu vermeiden.

Elektroden sind elektrisch leitfähige Komponenten, die dazu dienen, elektrischen Strom oder Spannung in ein Medium, insbesondere ein Elektrolyt oder Plasma, ein- oder auszukoppeln. Sie können aus verschiedenen Materialien wie Metallen, Kohlenstoff und/oder Halbleitern bestehen und finden Anwendung in einer Vielzahl von Geräten und Systemen, wie Batterien, Brennstoffzellen, Sensoren oder Entladungslampen. Durch die Wahl geeigneter Elektrodenmaterialien und -geometrien lassen sich die elektrischen Eigenschaften und Funktionen der Geräte gezielt beeinflussen.

Die Ausläufer können Teil der zweiten Elektrode sein und können für die Ionisierung des Fluids hohen Temperaturen standhalten. Ein hoher Leitwert ist nicht zwingend, jedoch müssen die Ausläufer grundsätzlich aus einem leitfähigen Material bestehen. Geeignete Materialien für die Auskäufer der zweiten Elektrode können Kupfer, Edelstahl, Wolframm und Siliziumcarbid sein.

Durch die vorliegende Erfindung wird eine Vorrichtung zur vorteilhaften Entwärmung eines Systems mittels einer elektrohydrodynamischen Pumpe bereitgestellt. Das ist deshalb der Fall, weil die auf die zu entwärmende Fläche des Systems aufgebrachte Bahnstruktur, an Ihren Ausläufern, als eine erste Elektrode, beim Anlegen einer Hochspannung, dass umgebene Fluid, insbesondere ein Gasgemisch wie Luft, ionisiert. Die ionisierten Teilchen werden durch die erste Elektrode, welche geerdet ist, angezogen und stellen eine Impulsübertragung durch Zusammenstöße mit anderen Teilchen des Fluids bereit. Diese Impulsübertragung mit einer großen Zahl von Teilchen löst einen Stofftransport aus, welcher als lonenwind bezeichnet wird. Der bereitgestellte Ionenwind ist auf die zu entwärmende Fläche gerichtet, da diese als die erste Elektrode ausgebildet ist, wobei mit dem Auftreffen des lonenwinds vorteilhafterweise eine Prallkühlung zur Entwärmung der zu entwärmenden Fläche bereitgestellt wird.

Die Lösung ist besonders vorteilhaft, da sie geräuscharm im Vergleich zu einem klassischen Lüfterrad ist und einen geringeren Einbauplatz gegenüber dem Lüfterrad und ganz besonders gegenüber üblichen elektrohydrodynamischen Pumpen aufweist, da die genutzten Ausläufer durch Flächenvergrößerung einen vergleichsweise deutlich stärkeren Ionenwind und damit bessere Entwärmungsleisung auf geringerer Einbaugröße bereitstellen.

Der lonenwind bezeichnet die Bewegung von Gasmolekülen, die durch den Impulsübertrag von geladenen Teilchen (Ionen) in einem elektrischen Feld hervorgerufen wird. Wenn Ionen in einem Gas beschleunigt werden, kollidieren sie mit den Gasmolekülen und übertragen ihnen einen Teil ihres Impulses. Dadurch werden die Gasmoleküle in Bewegung versetzt und es entsteht ein Gasfluss, der als lonenwind bezeichnet wird. Die Stärke des lonenwinds hängt von Faktoren wie der Ionendichte, dem elektrischen Feld und den Gasbedingungen ab.

Die Prallkühlung ist ein Verfahren zur Wärmeabfuhr oder auch zur Entwärmung, bei dem ein Fluid, insbesondere Luft oder Wasser, gezielt auf eine Oberfläche geleitet wird, um dort Wärme abzuführen. Dabei trifft ein Fluidstrahl senkrecht oder unter einem steilen Winkel auf die zu kühlende Fläche, wodurch eine intensive Wärmeübertragung durch Konvektion erreicht wird. Dieses Prinzip findet Anwendung in verschiedenen technischen Systemen, wie Elektromotoren, Transformatoren oder Elektronikkomponenten, um eine Überhitzung zu verhindern. Durch geeignete Auslegung der Düsengeometrie und des Fluidvolumenstroms lässt sich die Kühlleistung oder auch Entwärmungsleistung gezielt steuern und an den spezifischen Anwendungsfall anpassen.

Das erfindungsgemäße Verfahren für eine Auslegung einer Vorrichtung zur Entwärmung eines Systems mittels einer elektrisch leitfähigen Bahnstruktur und einer zu entwärmenden Fläche,
ist dadurch gekennzeichnet, dass
die auszulegende Bahnstruktur gemäß einem der vorhergehenden Ansprüche ausgebildet wird, umfassend folgende Schritte:
- Festlegen eines minimalen Abstands zwischen zwei Elektroden der Bahnstruktur abhängig von einer für die Elektroden vorgesehenen Hochspannung und/oder abhängig von den elektrischen Eigenschaften des die Elektroden umgebenden Fluid und/oder abhängig von einer durch die Vorrichtung zu erzielenden Entwärmungsleistung;
- Festlegen eines minimalen Abstands zwischen wenigstens zwei parallelen Ausläufern mit dem gleichen elektrischen Potential, abhängig von der zu erzielenden Entwärmungsleistung, wobei die Ausläufer als pfeilartige und/oder streifenartige Flächen bereitgestellt werden, welche an eine zweite Elektrode flächenmäßig anschließen und in eine Richtung einer ersten Elektrode ausgerichtet sind;
- Festlegen einer Länge und/oder Breite der jeweiligen ersten und/oder zweiten Elektrode, abhängig von der zu erzielenden Entwärmungsleistung.

Es ergeben sich zur erfindungsgemäßen Vorrichtung gleichartige, gleichwertige und gleichwirkende Vorteile.

Das erfindungsgemäße Computerprogrammprodukt umfasst Befehle, die bei der Ausführung des Programms durch eine Recheneinheit, insbesondere einen Computer, diesen veranlassen, eines der Verfahren und/oder Schritte der Verfahren gemäß dem Anspruch 10 auszuführen.

Es ergeben sich zum erfindungsgemäßen Verfahren gleichartige, gleichwertige und gleichwirkende Vorteile.

Gemäß einer vorteilhaften Ausgestaltung der Erfindung umfasst die Bahnstruktur eine Anordnung von sich abwechselnden ersten und zweiten Elektroden.

Der Begriff "abwechselnd" meint insbesondere, dass eine auf eine erste Elektrode eine zweite benachbarte Elektrode folgt und umgekehrt, wobei die Elektroden so angeordnet sein können, dass die jeweils entstehenden lonenwinde zwischen der ersten und zweiten Elektrode eine ähnliche räumliche Ausrichtung aufweisen.

Dadurch ist es vorteilhafterweise möglich eine Mehrzahl von Elektroden kaskadenartig zu verschalten, wobei durch die bereitgestellten lonenwinde einen Luftstrom kanalisieren, welcher vorteilhafterweise eine höhere Entwärmungsleistung erzielen kann, als ein Luftstrom, welcher durch einen lonenwind jeweils zwischen der einzelnen ersten und zweiten Elektrode erzeugt wird.

Mit anderen Worten bewirkt die kaskadenartige Verschaltung, dass ein Luftstrom stufenweise verstärkt werden kann, wobei jeweils die erste und zweite Elektrode eine Verstärkungsstufe bilden.

In einer vorteilhaften Weiterbildung der Erfindung ist die Bahnstruktur auf einem flexiblen und/oder aufklebbaren und/oder elektrisch isolierenden Substrat aufgebracht.

Der Begriff "flexibel" meint insbesondere, dass die Bahnstruktur auf einem kunststoffartigen oder gummiartigen flexiblen Substrat aufgebracht sein kann, wobei das Substrat sich der Form, der zu entwärmenden Fläche anpassen kann.

Der Begriff "aufklebbar" meint insbesondere, dass das Substrat mittels eines separat aufbringbaren Klebstoffes oder durch eine haftende Beschichtung aufklebbar sein kann, wobei eine Aufklebung auf der zu entwärmenden Fläche vorgenommen werden kann.

Dadurch kann vorteilhafterweise eine Installation auch an schwer erreichbaren Orten des zu entwärmenden Systems vorgenommen werden, wobei das Substrat vorteilhafterweise der Bahnstruktur weitere Stabilität verleihen kann.

Gemäß einer vorteilhaften Ausgestaltung der Erfindung ist die Bahnstruktur auf einem starren elektrisch isolierenden Substrat aufgebracht, wobei das Substrat wenigstens eine Bohrung aufweist.

Das starre elektrisch isolierende Substrat kann insbesondere aus dem üblichen Basismaterial einer Leiterplatte bestehen.

Die Bohrung kann eine einfache Bohrung mit festem Durchmesser sein oder bei einem dickeren Substrat mit einem Gewinde versehen sein.

Dadurch ist es vorteilhafterweise möglich, die Bahnstruktur mit einer zerstörungsfrei lösbaren Schraubverbindung zu installieren.

Gemäß einer vorteilhaften Ausgestaltung der Erfindung ist das zu entwärmende System eine elektrische Maschine und/oder eine Recheneinheit.

Die elektrische Maschine kann ein Motor und/oder ein Generator sein.

Die Recheneinheit kann eine speicherprogrammierbare Steuerung und/oder ein industrieller Computer sein.

Dadurch ist es vorteilhafterweise möglich sich im Betrieb erwärmende Systeme wie Motoren, Generatoren und/oder Recheneinheiten zu entwärmen und damit vorteilhafterweise eine bessere Betriebstemperatur bereitzustellen.

In einer vorteilhaften Weiterbildung der Erfindung sind die das Fluid ionisierenden Ausläufer durch räumliche Ausrichtung dazu ausgebildet, einen Kamineffekt zu unterstützen.

Der Kamineffekt kann auch als thermischer Auftrieb bezeichnet werden und beschreibt das Phänomen, beidem warme Luft oder Gase aufgrund ihrer geringeren Dichte im Vergleich zu kälterer Umgebungsluft nach oben steigen. Dieser Effekt entsteht, wenn ein Temperaturunterschied zwischen zwei Bereichen vorhanden ist und führt zu einer natürlichen Luftzirkulation. Der Kamineffekt wird beispielsweise in Schornsteinen, Lüftungsanlagen oder Solarschornsteinen genutzt, um Wärme abzuführen und einen Luftstrom zu erzeugen. Die Stärke des Kamineffekts hängt von Faktoren wie Temperaturunterschied, Höhe des Kamins und Querschnitt ab.

Dadurch kann vorteilhafterweise der natürliche Kamineffekt ausgenutzt werden, welcher den durch Ionenwind bereitgestellten Luftstrom weiter verstärkt und damit die Entwärmungsleistung erhöhen kann.

Gemäß einer vorteilhaften Ausgestaltung der Erfindung ist die Vorrichtung sandwitchartig mit einem Luftspalt zwischen der Bahnstruktur und der zu entwärmenden Fläche ausgebildet und die Bahnstruktur bildet gitterartig die zweite Elektrode aus, wobei die Ausläufer dieser zweiten Elektrode nadelartig als Körper ausgebildet sind und mit wenigstens einem Ende in Richtung der ersten Elektrode ausgerichtet sind.

Unter "sandwichartig" kann verstanden werden, dass die Bahnstruktur und die zu entwärmende Fläche auf jeweils einer separaten Eben im Raum angeordnet sind, wobei die beiden Ebenen parallel sein können.

Der Luftspalt kann ein Raum zwischen der zu entwärmenden Fläche (erste Elektrode) und der Bahnstruktur (zweite Elektrode) sein. Seine Breite oder auch die Entfernung zwischen Bahnstruktur und zu entwärmender Fläche kann abhängig von einer Durchschlagspannung einer an den Elektroden anliegenden Hochspannung sein.

Dadurch ist es vorteilhafterweise möglich eine noch effizientere Prallkühlung zu realisieren, da der Luftstrom näherungsweise senkrecht auf die zu entwärmende Fläche auftreffen kann. Darüber hinaus kann ein Substrat entfallen, da die gitterartige Struktur die für den Luftstrom benötigte Luft durchlassen können muss, wobei vorteilhafterweise das zusätzliche Gewicht für das Substrat entfallen kann.

In einer vorteilhaften Weiterbildung der Erfindung ist die stromführende Bahnstruktur aus der Spannungsversorgung des zu entwärmenden Systems speisbar.

Die Spannungsversorgung kann eine Gleich- oder Wechselspannung sein. Die Spannungsversorgung kann auch einer Modulation unterliegen, insbesondere Rechteckspannungen, Rampen oder Sägezähne sind möglich und können vorteilhafterweise einer Energieeinsparung dienen.

Dadurch kann vorteilhafterweise eine weitere Spannungsversorgung entfallen, was vorteilhafterweise zu einer Reduktion von Gewicht und zusätzlicher Beschaltung führen kann.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
Figur 1 zeigt schematisch eine Bahnstruktur aus zwei Elektroden, wobei eine Elektrode pfeilartige Ausläufer aufweist;
Figur 2 zeigt schematisch eine Bahnstruktur aus zwei Elektroden, wobei eine Elektrode keilartige Ausläufer aufweist;
Figur 3 zeigt schematisch die Installation der Vorrichtung an einem zu entwärmenden System; und
Figur 4 zeigt schematisch eine räumliche Anordnungsweise von einer Bahnstruktur als zweite Elektrode und einer zu entwärmenden Fläche als eine erste Elektrode.

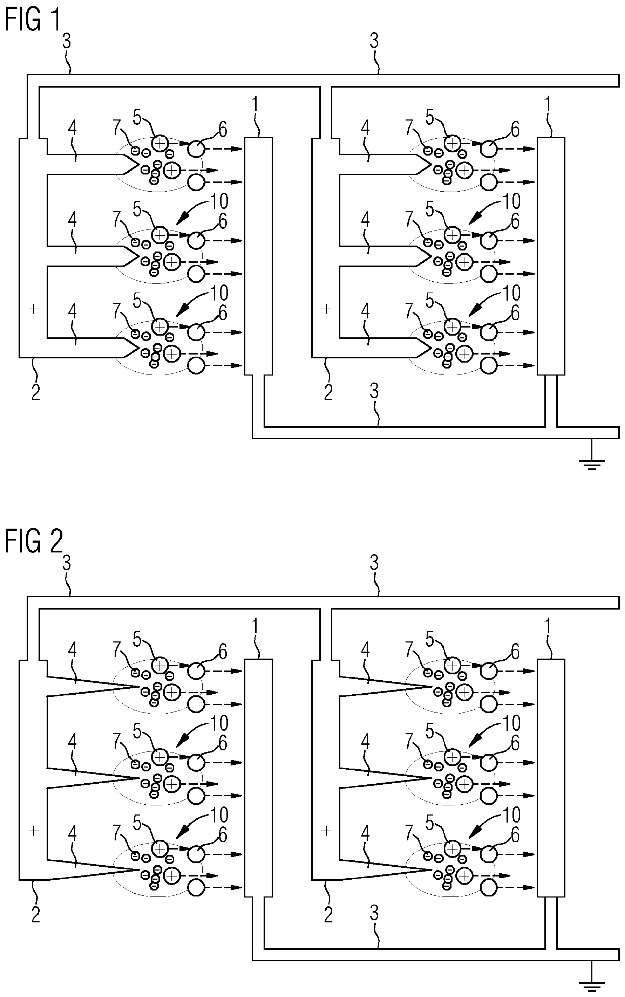

Figur 1 zeigt eine schematische Darstellung einer Bahnstruktur 3 aus zwei Elektroden 1,2, wobei eine zweite Elektrode 2 pfeilartige Ausläufer 4 aufweist.

Die schematische Darstellung zeigt eine Ausgestaltung mit zwei je paarweise angeordneten Elektroden 1,2. Mit anderen Worten wurden die Elektroden 1,2 abwechselnd angeordnet.

Beim Anlegen einer Hochspannung an der zweiten Elektrode 2 wird ein die Spitzen 4 umgebendes Fluid ionisiert. Es kommt hierbei zu einer Koronaentladung, bei welcher Ladungsträger 7 freigesetzt werden und Ionen 5 entstehen. Die Ionen 5 wandern zur geerdeten ersten Elektrode 1 und stellen durch Kollisionen mit andren Teilchen 6 eine Impulsübertragung bereit. Der hierdurch sich bildende Stofftransport oder auch Luftstrom ist in Richtung der ersten Elektrode 1 gerichtet und realisiert hierdurch eine Prallkühlung auf der zu entwärmenden Fläche 10 des zu entwärmenden Systems.

Figur 2 zeigt eine schematische Darstellung einer Bahnstruktur 3 aus zwei Elektroden 1,2, wobei eine zweite Elektrode 2 keilartige Ausläufer 4 aufweist.

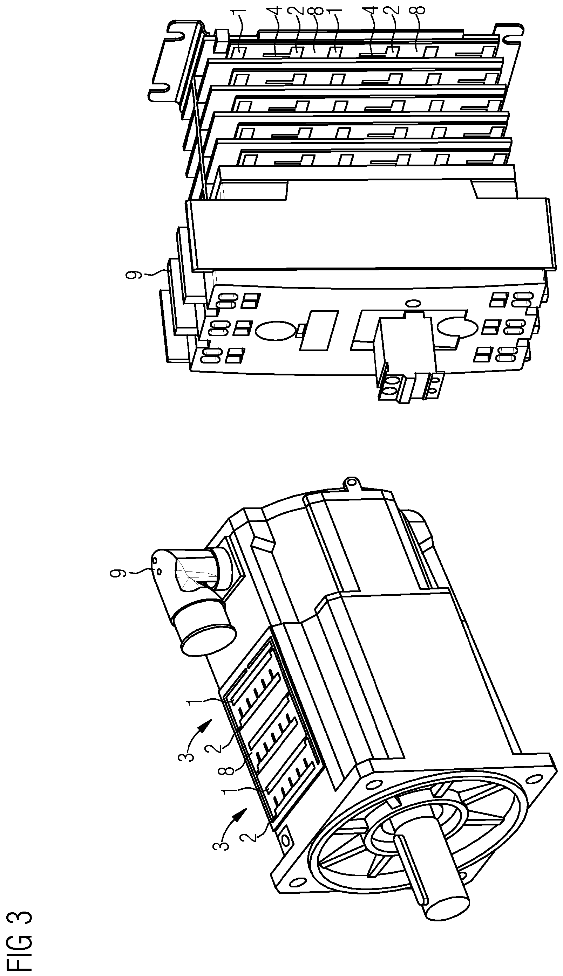

Figur 3 zeigt schematisch die Installation der Vorrichtung an einem zu entwärmenden System 9. Die Vorrichtung umfasst in dieser Ausgestaltung die Bahnstruktur 3, welche auf einem Substrat 8 aufgebracht ist, wobei das Substrat 8 mit einer zu entwärmenden Oberfläche 10 des zu entwärmenden Systems 9 verbunden ist.

Im linken Teil von Figur 3 ist das zu entwärmende System 9 ein Elektromotor, wobei die Vorrichtung auf dem Motorblock installiert ist. Durch eine Installation in der Nähe einer Energiezuführung des Elektromotors, kann die Vorrichtung über deren Energiezuführung versorgt werden. Hierdurch kann eine separate Zuführung von Energie vorteilhafterweise entfallen.

Im rechten Teil von Figur 3 ist das zu entwärmende System 9 eine Leistungselektronik und/oder Recheneinheit, wobei die Vorrichtung auf einer Kühlrippe eines Kühlkörpers der Leistungselektronik oder einer Einsteckkarte der Recheneinheit installiert sein kann. Die flache Bauform der Vorrichtung ermöglicht die Installation in schmalen Zwischenräumen und durch eine Ausrichtung des gewünschten Ionenwinds parallel zu einem möglichen Kaminfeffekt können sich diese beiden Phänomene gegenseitig vorteilhaft verstärken und die Entwärmungsleistung verbessern.

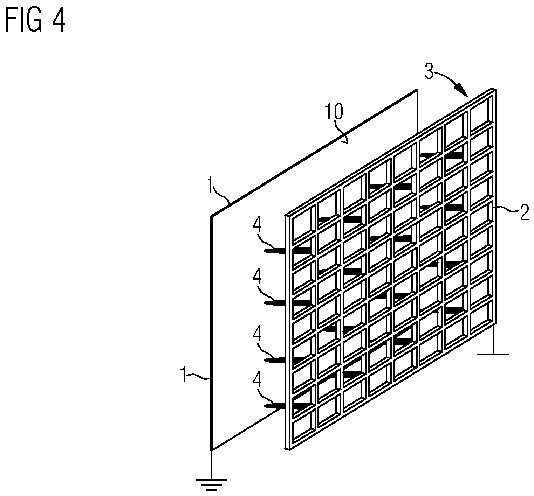

Figur 4 zeigt eine schematische Darstellung einer räumlichen Anordnungsweise der Vorrichtung, welche eine Bahnstruktur 3 als zweite Elektrode 2 und einer zu entwärmenden Fläche 10 als eine erste Elektrode 1 umfasst.

Die Ausgestaltung in Figur 4 sieht vor, die Prallkühlung mit einem näherungsweisen rechtwinkligen Einfallswinkel des Luftstroms zu realisieren. Hierzu ist die Bahnstruktur 3 der zweiten Elektrode 2 als ein Gitter ausgebildet, welches mit spitzen Ausläufern 4 besetzt ist.

Durch die Leerstellen im Gitter kann Luft als das zu ionisierende Fluid zirkulieren. Die Ionisierung der Luft findet an den Spitzen der Ausläufer 4 statt, wobei eine Hochspannung an der zweiten Elektrode 2 angelegt wird. Die ionisierten Teilchen wandern zur gegenüber angeordneten ersten Elektrode 1, da diese elektrisch geerdet ist. Bei dieser Wanderung von Teilchen werden durch Kollision und einhergehender Impulsübertragung weitere Teilchen im umgebenden Fluid in Bewegung versetzt und formen einen Luftstrom, welcher in Form einer Prallkühlung auf die erste Elektrode 1 auftreffen und die darunter liegende zu entwärmende Fläche 10 zu entwärmen.

In einer weiteren Ausgestaltung kann die zu entwärmende Fläche 10 auch die Funktion als erste Elektrode 1 erfüllen.

Gleichartige, gleichwertige oder gleichwirkende Elemente können in einer der Figuren oder in den Figuren mit denselben Bezugszeichen versehen sein.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1: erste Elektrode
- 2: zweite Elektrode
- 3: Bahnstruktur
- 4: Ausläufer
- 5: ionisiertes Teilchen
- 6: durch Impulsübertragung bewegtes Teilchen
- 7: freigesetzter Ladungsträger
- 8: Substrat
- 9: zu entwärmendes System
- 10: zu entwärmende Fläche

## Patentansprüche

1. Vorrichtung zur Entwärmung eines Systems umfassend eine elektrisch leitfähige Bahnstruktur (3) und eine zu entwärmende Fläche (10) des Systems (9),
wobei
die elektrisch leitfähige Bahnstruktur (3) für eine Entwärmung der zu entwärmenden Fläche (10) auf die zu entwärmende Fläche (10) aufgebracht ist, wobei die Bahnstruktur (3) wenigstens zwei Elektroden (1,2) umfasst, wobei eine erste Elektrode (1) elektrisch geerdet ausgebildet ist, eine zweite Elektrode (2) als eine Anode gegenüber der ersten Elektrode (1) ausgebildet ist und die erste und zweite Elektrode (2) jeweils benachbart und/oder parallel zueinander in einer gemeinsamen räumlichen Ebene angeordnet sind und die zweite Elektrode (2) mit in der selben räumlichen Ebene angeordneten pfeilartigen und/oder streifenartigen Flächen als Ausläufer (4) besetzt ist, welche parallel zueinander angeordnet sind, wobei die Ausläufer (4) mit einem jeweiligen Ende auf die jeweils benachbarte parallel angeordnete erste Elektrode (1) zeigen und bei einer anliegenden Hochspannung dazu ausgebildet sind, ein die Ausläufer (4) umgebendes Fluid zu ionisieren.

2. Vorrichtung gemäß Anspruch 1, **dadurch gekennzeichnet, dass** die Bahnstruktur (3) eine Anordnung von sich abwechselnden ersten und zweiten Elektroden (1,2) umfasst.

3. Vorrichtung gemäß einem der vorhergehenden Ansprüche, **dadurch gekennzeichnet, dass** die Bahnstruktur (3) auf einem flexiblen und/oder aufklebbaren und/oder elektrisch isolierenden Substrat (8) aufgebracht ist.

4. Vorrichtung gemäß einem der vorhergehenden Ansprüche, **dadurch gekennzeichnet, dass** die Bahnstruktur (3) auf einem starren elektrisch isolierenden Substrat (8) aufgebracht ist, wobei das Substrat (8) wenigstens eine Bohrung aufweist.

5. Vorrichtung gemäß einem der vorhergehenden Ansprüche, **dadurch gekennzeichnet, dass** das zu entwärmende System (9) eine elektrische Maschine und/oder eine Recheneinheit ist.

6. Vorrichtung gemäß einem der vorhergehenden Ansprüche, **dadurch gekennzeichnet, dass** die das Fluid ionisierenden Ausläufer (4) durch räumliche Ausrichtung dazu ausgebildet sind, einen Kamineffekt zu unterstützen.

7. Vorrichtung gemäß einem der vorhergehenden Ansprüche, **dadurch gekennzeichnet, dass** die Vorrichtung sandwichartig mit einem Luftspalt zwischen der Bahnstruktur (3) und der zu entwärmenden Fläche (10) ausgebildet ist und die Bahnstruktur (3) gitterartig die zweite Elektrode (2) ausbildet, wobei die Ausläufer (4) dieser zweiten Elektrode (2) nadelartig als Körper ausgebildet sind und mit wenigstens einem Ende in Richtung der ersten Elektrode (1) ausgerichtet sind.

8. Vorrichtung gemäß einem der vorhergehenden Ansprüche, **dadurch gekennzeichnet, dass** die stromführende Bahnstruktur (3) aus der Spannungsversorgung des zu entwärmenden Systems (9) speisbar ist.

9. Verfahren für eine Auslegung einer Vorrichtung zur Entwärmung eines Systems umfassend eine elektrisch leitfähige Bahnstruktur (3) und eine zu entwärmende Fläche (10),
**dadurch gekennzeichnet, dass**
die auszulegende Bahnstruktur (3) gemäß einem der vorhergehenden Ansprüche ausgebildet wird, umfassend folgende Schritte:
- Festlegen eines minimalen Abstands zwischen zwei Elektroden (1,2) der Bahnstruktur (3) abhängig von einer für die Elektroden vorgesehenen Hochspannung und/oder abhängig von den elektrischen Eigenschaften des die Elektroden umgebenden Fluid und/oder abhängig von einer durch die Vorrichtung zu erzielenden Entwärmungsleistung;
- Festlegen eines minimalen Abstands zwischen wenigstens zwei parallelen Ausläufern (4) mit dem gleichen elektrischen Potential, abhängig von der zu erzielenden Entwärmungsleistung, wobei die Ausläufer (4) als pfeilartige und/oder streifenartige Flächen bereitgestellt werden, welche an eine zweite Elektrode (2) flächenmäßig anschließen und in eine Richtung einer ersten Elektrode (1) ausgerichtet sind;
- Festlegen einer Länge und/oder Breite der jeweiligen ersten und/oder zweiten Elektrode (2), abhängig von der zu erzielenden Entwärmungsleistung.

10. Computerprogrammprodukt, umfassend Befehle, die bei der Ausführung des Programms durch eine Recheneinheit, insbesondere einen Computer, diesen veranlassen, eines der Verfahren und/oder Schritte der Verfahren gemäß dem Anspruch 9 auszuführen.
